# EUROPEAN PATENT APPLICATION

(11) **EP 4 138 130 A1**
(43) Date of publication of application: **22.02.2023**
(21) Application number: 21191573.1
(22) Date of filing: 16.08.2021
(51) Int. Cl.: H01L 27/02, H02H 9/04

(54) **CIRCUIT ARRANGEMENT**

(71) Applicant: Infineon Technologies Austria AG, 9500 Villach (AT)
(72) Inventor: WEIS, Rolf, 01109 Dresden (DE); DEICHLER, Josef, 01109 Dresden (DE); FEICK, Henning, 01099 Dresden (DE)
(74) Representative: Westphal, Mussgnug & Partner, Patentanwälte mbB

(57) **Abstract**

Disclosed is a circuit arrangement. The circuit arrangement includes: an electronic circuit (1) integrated in a semiconductor body (100); an input pin (IN) coupled to the electronic circuit (1); an insulation layer (3) formed on top of the semiconductor body (100); and a protection device (2) connected to the input pin (IN). The protection device is integrated in a polysilicon layer (4) formed on top of the insulation layer (3).

## Description

This disclosure relates in general to a circuit arrangement, in particular a circuit arrangement with an electronic circuit integrated in a semiconductor body and at least one protection device, such as an electrostatic discharge (ESD) device.

There is a need to provide a circuit arrangement with an integrated electronic circuit and a protection device in which the protection device is implemented in a space saving way.

One example relates to a circuit arrangement. The circuit arrangement includes an electronic circuit integrated in a semiconductor body, an input pin coupled to the electronic circuit, an insulation layer formed on top of the semiconductor body, and
a protection device connected to the input pin. The protection device is integrated in a polysilicon layer formed on top of the insulation layer.
Figure 1 schematically illustrates a circuit arrangement that includes an electronic circuit integrated in a semiconductor body, an input pin connected to the electronic circuit, and a protection device integrated in a polysilicon layer arranged on top of an insulation layer;
Figures 2A and 2B shows a protection device and a corresponding circuit diagram, respectively, of a protection device according to one example;
Figures 3A and 3B shows a protection device and a corresponding circuit diagram, respectively, of a protection device according to another example;
Figure 4 shows a modification of the protection device according to Figure 2A;
Figure 5 shows a modification of the protection device according to Figure 3A;
Figure 6 shows a top view of a protection device according to one example:
Figure 7 illustrates one example for coupling a protection device to the semiconductor body;
Figure 8 illustrates another example for coupling a protection device to the semiconductor body;
Figure 9 shows a top view of the arrangement shown in Figure 8;
Figure 10 shows one example of a circuit arrangement with an electronic circuit and several protection devices; and
Figure 11 schematically illustrates a top view of a semiconductor body of the arrangement shown in Figure 10.

In the following detailed description, reference is made to the accompanying drawings. The drawings form a part of the description and for the purpose of illustration show examples of how the invention may be used and implemented. It is to be understood that the features of the various embodiments described herein may be combined with each other, unless specifically noted otherwise.

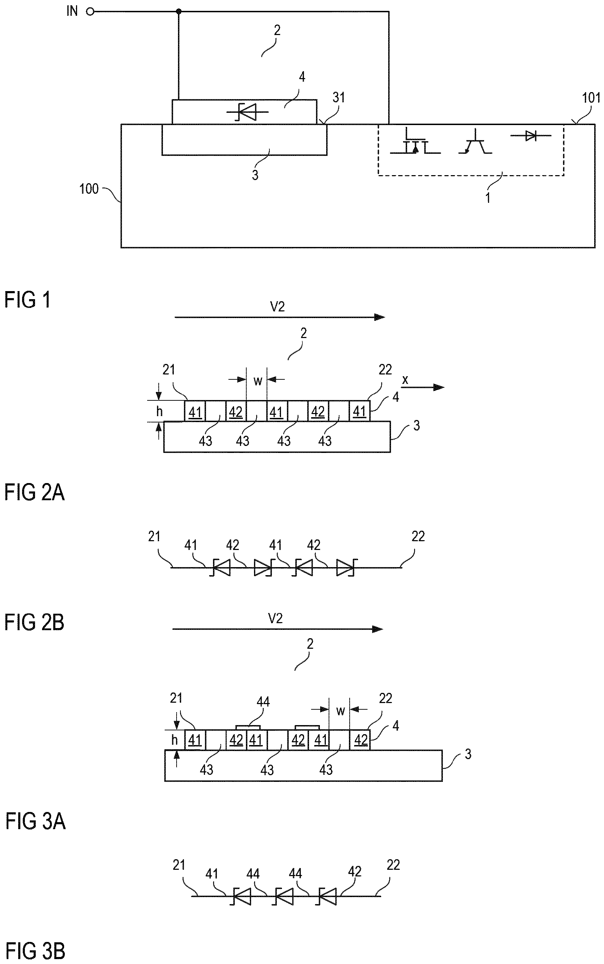

Figure 1 schematically illustrates one example of a circuit arrangement. The circuit arrangement includes an electronic circuit 1 that is integrated in a semiconductor body 100. Figure 1 schematically illustrates a vertical cross sectional view of the semiconductor body 100. The semiconductor body 100 includes a top surface 101. The section plane shown in Figure 1 cuts through the semiconductor body 100 in a direction that is essentially perpendicular to the top surface 101 of the semiconductor body 100.

The integrated electronic circuit 1 may be any kind of electronic circuit that is capable of being integrated in a semiconductor body, such as the semiconductor body 100 illustrated in Figure 1. The integrated circuit 1 may be implemented using any type of electronic devices that can be integrated in a semiconductor body. Examples of such electronic devices include, without being restricted to, transistors, e.g., MOSFETs (Metal Oxide Semiconductor Field-Effect Transistors), BJTs (Bipolar Junction Transistors); diodes; resistors; capacitors, or the like. Just for the purpose of illustration, a circuit symbol of a MOSFET, of a BJT and a diode is schematically illustrated in Figure 1, wherein these devices represent electronic devices integrated in the electronic circuit 1. According to one example, the integrated electronic circuit is a CMOS circuit.

Referring to Figure 1, the circuit arrangement further includes an insulation layer 3 formed on top of the semiconductor body 100, a protection device 2, and an input pin IN. The input pin IN, which is only schematically illustrated in Figure 1, is connected to the electronic circuit 1 and the protection device 2. Furthermore, the protection device 2 is integrated in a polysilicon layer 4 that is formed on top of the insulation layer 3. The protection device 2 may include one or more Zener or Avalanche diodes and is not illustrated in detail in Figure 1. Examples for implementing the protection device 2 are explained in detail herein further below.

Referring to the above, the insulation layer 3 is formed on top of the semiconductor body 100. This includes that the insulation layer 3 is not entirely encapsulated by the semiconductor body 100, so that a surface on top of which the polysilicon layer 4 is formed is not covered by the semiconductor body 100. The insulation layer 3 may be arranged in a cavity (a trench) of the semiconductor body 100, so that a surface 31 of the insulation layer 3 and the top surface 101 of the semiconductor body 100 are essentially coplanar (as illustrated in Figure 1). This, however, is only an example. According to another example (not illustrated), the insulation layer 3 is formed on top of the top surface 101 of the semiconductor body 100 by a deposition process. According to one example, the deposition process is a PECVD (Plasma Enhanced Vapor Deposition) process. According to yet another example (not shown), forming the insulation layer includes an oxidation process, so that a semiconductor oxide is formed as the insulation layer 3. In this example, the insulation layer 3 may extend into the semiconductor body 100 and, at the same time, may extend beyond the top surface 101 of the semiconductor body 100. According to one example, oxidation process is a LOCOS (Local Oxidation of Silicon) process.

According to one example, the semiconductor body 100 includes a monocrystalline semiconductor material such as, for example, silicon (Si), silicon carbide (SiC), gallium nitride (GaN), or the like. According to one example, the insulation layer 3 includes a semiconductor oxide, such as silicon oxide, or a nitride.

A thickness of the polysilicon layer 4, which is a dimension of the polysilicon layer 4 in a direction perpendicular to the surface 31 of the insulation layer 3, is selected from between 50 nanometers (nm) and 300 nanometers, in particular from between 100 nanometers and 200 nanometers. A thickness of the insulation layer 3, which is the dimension of the insulation layer 3 in a direction perpendicular to the surface 31, is selected from between 50 nanometers and 500 nanometers, for example. According to one example, the thickness is selected from between 100 nanometers and 400 nanometers, in particular from between 100 nanometers and 200 nanometers.

Figure 2A illustrates one example of the protection device 2, Figure 2B shows an equivalent circuit diagram of the protection device 2 according to Figure 2A. Figure 2A only illustrates the insulation layer 3 and the polysilicon layer 4 formed on top of the surface 31 of the insulation layer 3. The semiconductor body is not illustrated in Figure 2A.

Referring to Figure 2A, the protection device 2 includes a plurality of first regions 41 of a first doping type and a plurality of second regions 42 of a second doping type complementary to the first doping type. The first regions 41 and the second regions 42 are arranged alternatingly in a first lateral direction x of the polysilicon layer 4. According to one example, a doping concentration of each of the first and second regions 41, 42 is selected from between 1E19 cm⁻³ and 1E21 cm⁻³. Optionally, the protection device 2 further includes a plurality of third regions 43, wherein each of these intrinsic regions 43 is arranged between a first region 41 and a neighboring second region 42, so that each first region 41 is separated from each neighboring second region 42 by a respective third region 43 and each second region 42 is separated from each neighboring first region 41 by a respective third region 43.

According to one example, the third regions 43 are intrinsic regions. According to one example, "intrinsic" includes that the third regions 43 are non-doped or not intentionally doped polysilicon regions. According to the example, "non-doped or not intentionally doped" includes that the effective doping concentration is equal to or lower than 1E15 cm⁻³.

According to another example, the third regions 43 are lowly doped regions. According to one example, lowly doped includes that there is an intentional doping, wherein the doping concentration is less than 1%, less than 0.1%, or less than 0.01% of the doping concentration of each of the first regions 41 and the second regions 42 and/or wherein the effective doping concentration is lower than 1E17 cm⁻³ or lower than 1E16 cm⁻³.

One example for forming the polysilicon layer 4 with the first and second regions 41, 42 and the third regions 43 includes depositing a polysilicon layer on top of the insulation layer 3, forming the first regions 41 by implanting dopant atoms of the first doping type, and forming the second regions 42 by implanting dopant atoms of the second doping type. More specifically, forming the first regions 41 may include forming a first implantation mask on top of the polysilicon layer 4, wherein the first implantation mask does not cover those regions of the polysilicon layer 4 in which the first regions 41 are to be formed, and implanting first type dopant atoms into the polysilicon layer 4 via the openings in the first implantation mask. Equivalently, forming the second regions 42 may include forming a second implantation mask on top of the polysilicon layer 4, wherein the second implantation mask does not cover those regions of the polysilicon layer 4 in which the second regions 42 are to be formed, and implanting second type dopant atoms into the polysilicon layer 4 via respective openings in the second implantation mask. The third regions 43 are not doped when the first and second regions 41, 42 are formed, so that the third regions 43 have the basic doping of the polysilicon layer. The basic doping of the polysilicon layer is a doping concentration as the polysilicon layer 4 has after depositing the polysilicon layer 4 on top of the insulation layer 3. According to one example, the polysilicon layer is an intrinsic layer, so that the third regions 43 are intrinsic regions. According to another example, the polysilicon layer is a lowly doped layer, so that the third regions 43 are lowly doped regions.

Another example for forming the polysilicon layer 4 with the first and second regions 41, 42 and the third regions 43 is based on method explained above and additionally includes forming a third mask on top of those regions of the polysilicon layer that form the third regions 43 in the finished device. The third mask is formed before forming the first and second implantation masks and remains in place during the implantation processes that form the first and second regions 41, 42. The third mask acts as a blocking template and defines the geometry of the third regions 43, and is removed after forming the first and second regions 41, 42. Like in the method explained above, the third regions 43 are regions that have the basic doping of the polysilicon layer. According to one example, the polysilicon layer is an intrinsic layer, so that the third regions 43 are intrinsic regions. According to another example, the polysilicon layer is a lowly doped layer, so that the third regions 43 are lowly doped regions.

Another example for forming the polysilicon layer 4 with the first and second regions 41, 42 and the third regions 43 includes forming the third mask on top of those regions of the polysilicon layer that form the third regions 43 in the finished device. The method further includes a first implantation process in which dopant atoms of one of the first doping type and the second doping type are implanted into those regions of the polysilicon layer not covered by the third implantation mask. The method further includes forming one of the first and second implantation masks and implanting dopant atoms of the other one of the first and second dopant atoms, wherein an implantation dose in the second implantation process is higher than in the first implantation process, so that regions not covered by the implantation mask in the second implantation process change their effective doping type. According to one example, the implantation dose in the second implantation process is twice the implantation dose in the first implantation process, or higher.

According to one example, the first implantation process includes implanting dopant atoms of the first doping type and the second implantation process includes implanting dopant atoms of the second doping type. In this example, the second implantation mask is formed before the second implantation process, wherein the second implantation mask does not cover those regions of the polysilicon layer 4 in which the second regions 42 are to be formed. In this process, the first regions 41 are those regions that are covered by the second and third implantation masks in the second implantation process. A doping concentration of the first regions 41 is defined by a basic doping of the polysilicon layer and the implantation dose in the first implantation process, and a doping concentration of the second regions 42 is defined by the basic doping of the polysilicon layer, the implantation dose in the first implantation process, and the implantation dose in the second implantation process. Furthermore, the doping concentration of the third regions 43 is defined by the basic doping of the polysilicon layer. If, for example, the polysilicon layer is an intrinsic layer and the implantation dose in the second implantation process is twice the implantation dose in the first implantation process, the third regions 43 are intrinsic, the first regions 41 are regions of the first doping type, and the second regions 42 are regions of the second doping type, wherein an effective doping concentration of the second regions 42 essentially equals the effective doping concentration of the first regions 41.

According to another example, the first implantation process includes implanting dopant atoms of the second doping type and the second implantation process includes implanting dopant atoms of the first doping type. In this example, the first implantation mask is formed before the second implantation process, wherein the first implantation mask does not cover those regions of the polysilicon layer 4 in which the first regions 41 are to be formed. In this process, the second regions 42 are those regions that are covered by the first and third implantation masks in the second implantation process. A doping concentration of the second regions 42 is defined by a basic doping of the polysilicon layer and the implantation dose in the first implantation process, and a doping concentration of the first regions 41 is defined by the basic doping of the polysilicon layer, the implantation dose in the first implantation process, and the implantation dose in the second implantation process. Furthermore, the doping concentration of the third regions 43 is defined by the basic doping of the polysilicon layer. If, for example, the polysilicon layer is an intrinsic layer and the implantation dose in the second implantation process is twice the implantation dose in the first implantation process, the third regions 43 are intrinsic, the first regions 41 are regions of the first doping type, and the second regions 42 are regions of the second doping type, wherein an effective doping concentration of the second regions 42 essentially equals the effective doping concentration of the first regions 41.

In the examples explained before in which the first regions 41 or the second regions 42 include first and second type dopant atoms resulting from the first and second implantation process, the polysilicon layer is not necessarily an intrinsic layer. It is also possible to form the polysilicon layer as a lowly doped layer, wherein the dopant atoms are introduced either during the deposition process or by a blanket implantation process before forming the third implantation mask. The basic doping of the polysilicon layer may be considered in adjusting the implantation doses in the first and second implantation process in order to achieve a desired doping concentration of the first and second regions 41, 42. Furthermore, the order in which the first and second implantation processes are carried out is arbitrary.

According to another example, in the method explained above, the third implantation mask is omitted, so that the first implantation process is a blanket process in which dopant atoms are also implanted into those regions in which the third regions 43 are to be formed. This method further includes the second implantation process that uses the first or second implantation mask and that forms the first or second regions 41, 42. In addition to the second implantation process, this method further includes forming a further implantation mask that covers the first and second regions 41, 42 and does not cover those sections in which the third regions 43 are to be formed, and a third implantation process. A third implantation dose in the third implantation process is adjusted such that, given the dopant atoms that were implanted in the first implantation process, a desired doping concentration of the third regions 43 is achieved.

In the protection device 2 according to Figure 2A, each arrangement including a first region 41, a neighboring second region 42, and the optional third region 43 arranged between the first region 41 and the second region 42 forms a Zener or Avalanche diode, wherein one of the first and second regions 41, 42 forms a cathode and the other one of the first region 41, and the second region 42 forms an anode of the respective Zener or Avalanche diode. According to one example, the first regions 41 are n-type regions and the second regions 42 are p-type regions, so that the first regions 41 form cathodes of the Zener or Avalanche diodes and the second regions 42 form anodes of the Zener or Avalanche diodes.

As can be seen from the equivalent circuit diagram shown in Figure 2B, the plurality of first regions 41 and the plurality of second regions 42 and the optional third regions 43 form a series circuit with a plurality of Zener diodes wherein neighboring diodes in the series connection are connected in a back-to-back configuration. This includes, that the cathode of one Zener or Avalanche diode is connected to the cathode of the neighboring Zener or Avalanche diode or the anode of one Zener or Avalanche diode is connected to the anode of the neighboring Zener or Avalanche diode. This is due to each first region 41 being arranged between two second regions 42 forming the cathode of the two Zener or Avalanche diodes formed by the first region 41 and the two second regions 42, and, equivalently, each second region 42 being arranged between two first regions 41 forming the anode of two Zener or Avalanche diodes formed by the second region 42 and the two neighboring first regions 41.

Figure 3A shows a modification of the protection device 2 according to Figure 2A, Figure 3B shows an equivalent circuit diagram of the protection device 2 according to Figure 3A. Referring to Figures 2A and 2B, each pair including a first region 41 and a neighboring second region 42 forms a Zener diode, so that, referring to Figure 2B, the protection device includes a plurality of Zener diodes which are connected in a back-to-back configuration.

In the protection device 2 according to Figures 3A and 3B, every second Zener or Avalanche diode in the series circuit is bypassed (short-circuited), so that the protection device 2 effectively includes a series circuit with a plurality of Zener or Avalanche diodes which are orientated in the same way. That is, each of the Zener or Avalanche diodes in this series circuit has its anode connected to the cathode of another Zener or Avalanche diode and/or has its cathode connected to the anode of another Zener or Avalanche diode. Referring to Figure 3A, bypassing a Zener or Avalanche diode may include electrically connecting the first region 41 and the second region 42 forming the respective Zener or Avalanche diode. "Electrically connecting" may include forming a conductor 44 on top of the respective first region 41 and the respective second region 42, wherein the conductor 44 ohmically contacts the first region 41 and the respective second region 42. According to one example, the conductor 44 includes at least one of a metal or a silicide. Examples of the metal include copper (Cu), aluminum (Al), titanium (Ti), tungsten (W), tantalum (Ta), cobalt (Co) or the like. Examples of the silicide include titanium silicide (TiSi), cobalt silicide (CoSi), nickel silicide (NiSi), or the like.

In the example shown in Figure 3A, those first and second regions 41, 42 that are electrically connected by a respective conductor 44 adjoin each other. This, however, is only an example. According to another example (not illustrated) a third region is arranged between the first region 41 and the second region 42 that are electrically connected. In this example, the conductor 44 extends from the first region 41 along the third region 43 to the second region 42.

Referring to Figures 2A - 2B and 3A - 3B, the protection device 2 includes a first circuit node 21 and a second circuit node 22, wherein each of these circuit nodes 21, 22 may be formed by a respective one of the first regions 41 or a respective one of the second regions 42.

The protection device 2 has a voltage blocking capability and is capable of conducting a current between the first circuit node 21 and the second circuit node 22 when a voltage between the first circuit node 21 and the second circuit node 22 reaches a voltage level defined by the voltage blocking capability. For the purpose of illustration it is assumed that a voltage V2 is applied between the first circuit node 21 and the second circuit node 22. This voltage V2 may have a first polarity or an opposite second polarity. Just for the purpose of illustration it is assumed that the first polarity is associated with an electrical potential at the first circuit node 21 being higher than an electrical potential at the second circuit node 22, and that the second polarity is associated with the electrical potential at the second circuit node 22 being higher than the electrical potential at the first circuit node 21. Dependent on the implementation, the protection device 2 may block the voltage V2 independent of its polarity or may block only when the voltage V2 has one of the first and second polarities and conduct when the voltage V2 has the other one of the first and second polarities.

A protection device configured to block the voltage V2 independent of its polarity is referred to as bidirectionally blocking protection device in the following. Equivalently, a protection device that is configured to block only a voltage with one polarity is referred to as unidirectionally blocking protection device in the following.

The protection device according to Figures 2A - 2B that includes a plurality of Zener or Avalanche diodes connected in a back-to-back configuration is a bidirectionally blocking protection device. In this protection device, a first group of Zener diodes is reverse biased and a second group of Zener diodes is forward biased when the voltage V2 has the first polarity. Equivalently, the Zener diodes of the second group are reverse biased and the Zener diodes of the first group are forward biased when the voltage V2 has the second polarity. When the voltage V2 has the first polarity, the voltage blocking capability of the protection device 2 is essentially given by the sum of the voltage blocking capabilities of the Zener diodes of the first group. Equivalently, when the voltage V2 has the second polarity, the voltage blocking capability of the protection device 2 is essentially given by the sum of the voltage blocking capabilities of the Zener diodes of the second group.

The protection device 2 according to Figures 3A - 3B is a unidirectionally blocking protection device. More specifically, the protection device 2 only blocks when the voltage V2 has the first polarity. The voltage blocking capability is given by the sum of the voltage blocking capabilities of the (not short circuited) Zener or Avalanche diodes in the series circuit. The protection device 2 according to Figures 3A - 3B conducts when the voltage V2 has the second polarity and has a voltage level that is higher than a sum of the forward voltages of the Zener or Avalanche diodes.

In each case, when one of the protection devices 2 according to Figures 2A - 2B or 3A - 3B is operated in a blocking state, the protection device 2 breaks through and conducts a current when a voltage level of the voltage V2 reaches the respective voltage blocking capability. In this way, the protection device 2 clamps the voltage level of the voltage V2 and prevents the voltage from increasing further. The "blocking state", is the operating state in which Zener or Avalanche diodes in the series circuit are reverse biased.

Referring to the above, the voltage blocking capability of the protection device 2 is given by the sum of the voltage blocking capabilities of the Zener or Avalanche diodes that are reverse biased in the respective operating state of the protection device 2. The voltage blocking capability of a singular Zener or Avalanche diode can be adjusted by suitably selecting a width w of the third region 43 separating the first region 41 and the second region 42 of the respective Zener or Avalanche diode. Basically, the voltage blocking capability increases as the distance w increases. It can be shown that, for a certain range of the width w, the voltage blocking capability of the Zener or Avalanche diode linearly increases dependent on the width w. Referring to the above, it may be desirable for the protection device 2 to break through and conduct a current between the first and second circuit nodes 21, 22 when the voltage V2 reaches a voltage level defined by the voltage blocking capability of the protection device 2. Such voltage level may result from an ESD event, for example.

It may further be desirable that the protection device 2 features a low resistance between the first circuit node 21 and the second circuit node 22 when the voltage V2 reaches the voltage level defined by the voltage blocking capability (that is, when the voltage V2 reaches the breakdown voltage). Basically, the current through a reverse biased Zener diode increases exponentially when the voltage across the Zener diode reaches the breakdown voltage and further increases. It can be shown that the increase of the voltage through the Zener diode is dependent on the width w of the third region 43 wherein the higher the width w, the lower the increase of the current through the Zener diode. Furthermore, it can be shown that a protection device having a certain voltage blocking capability and being capable of conducting a certain current after the voltage blocking capability (the breakdown voltage) has been reached can be implemented in a space saving way when implementing several Zener diodes connected in series, as compared to implementing only one Zener diode with a relatively wide third region.

According to one example, the voltage blocking capability of each Zener or Avalanche diode is between 5V and 10V. According to one example, an overall voltage blocking capability of the protection device is between 10V and 300V, in particular between 100V and 220V.

According to one example, the protection device 2 includes between 3 and 30 first regions 41, and 3 and 30 second regions 42, so that the protection device 2 includes between 3 and 30 Zener or Avalanche diodes in a protection device according to Figure 3 or between 6 and 60 Zener or Avalanche diodes in a protection device according to Figure 2. According to one example, the width w of each of the third regions 43 is selected from between 0.1 micrometers (µm) and 1 micrometer, in particular from between 0.1 micrometers and 0.4 micrometers. The width of the first and second regions 41, 42 may be selected from the same range as the width of the third regions 43.

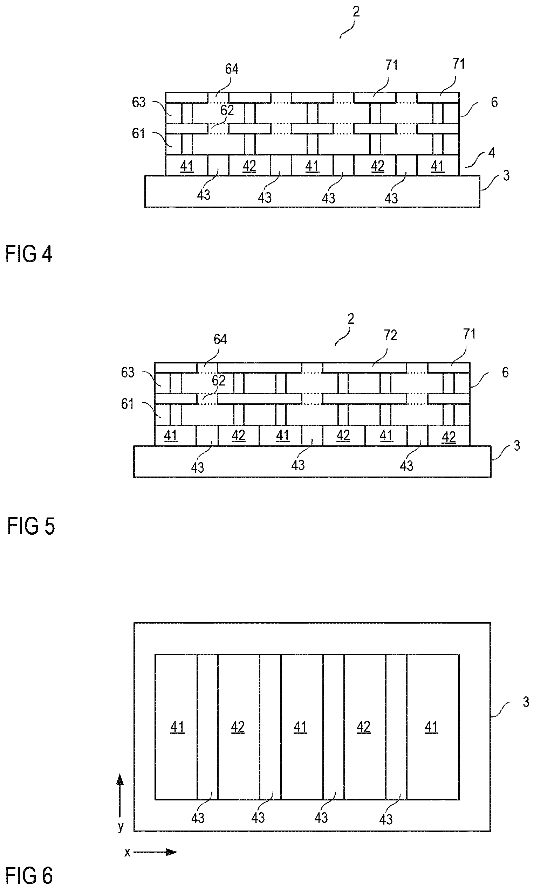

When the voltage V2 applied between the first and second circuit nodes 21, 22 reaches the breakdown voltage and a current flows through the protection device 2 energy may be dissipated in the polysilicon layer 4, wherein this may cause the polysilicon layer 4 to heat up. According to one example, the protection device 2 includes cooling fins that serve to conduct heat away from the polysilicon layer 4. Examples of how such cooling fins may be implemented are illustrated in Figures 4 and 5, wherein each of these Figures shows a vertical cross sectional view of the insulation layer 3, the polysilicon layer 4, and the respective cooling fins.

The protection device 2 according to Figure 4 includes a plurality of cooling fins 71, wherein each of these cooling fins adjoins a respective one of the first regions 41 and the second regions 42, and wherein the cooling fins 71 are electrically insulated from each other. In the example shown in Figure 4, each of the first and second regions 41, 42 has a cooling fin 71 attached thereto. This, however, is only an example. According to another example (not shown) at least one but less than each of the first and second regions 41, 42 has a respective cooling fin 71 attached thereto.

Referring to Figure 4, each of the cooling fins 71 adjoins a respective one of the first and second regions 41, 42. Each of the cooling fins 71 includes a thermally conductive material. According to one example, the cooling fins 71 include a metal such as, copper, aluminum, tungsten, titanium, tantalum or the like. Each of the cooling fins 71 may include only one type of metal. According to another example, each cooling fin 71 includes two or more sections or layers that include different types of metals.

Referring to Figure 4, the cooling fins 71 may be arranged in an insulation layer 6 formed on top of the polysilicon layer 4. The insulation layer 6 may include several sublayers 61 - 64. In this example, each cooling fin 71 may include several sections, wherein these sections are thermally (and electrically) connected, and wherein each of these sections is arranged in a respective one of the sublayers 61 - 64. According to one example, the cooling fins 71 are formed by the same process in which a wiring arrangement of the integrated circuit is formed on top of the semiconductor layer 100. The wiring arrangement may include several metallization layers, wherein the metallization layers may be connected by electrically conducting vias. Consequently, the cooling fin 71 may include sections that are formed by metallization layers of the wiring arrangement and other sections that are formed by electrically conducting vias. According to one example, sublayers 62, 64 shown in Figure 4 are sublayers of the insulation layer that include metallization layers of the wiring arrangement, and sublayers 61, 63 are layers that include electrically conducting vias. Consequently, in the example shown in Figure 4, the cooling fins 71 include sections of two different metallization layers and two electrically conducting vias that connect the sections of the metallization layer with each other and with the respective first or second region 41, 42, respectively.

Figure 5 illustrates cooling fins according to another example. In this example, the protection device 2 includes cooling fins 72 that electrically connect a first region 41 and a second region 42. In this example, each cooling fin 72, in addition to conducting heat away from the first and second regions 41, 42 it is connected thereto, has the same function as the connection 44 according to Figure 3A and therefore serves to bypass (short circuit) a respective Zener or Avalanche diode.

Referring to the above, the first and second regions 41, 42 are arranged alternatingly in the first lateral direction x. In a second lateral direction y perpendicular to the first lateral direction x, the first and second regions 41, 42 may be elongated. That is, a dimension of the first and second regions 41, 42 in the second lateral direction y may be greater than a respective dimension in the first lateral direction x. This is schematically illustrated in Figure 6 which shows a top view of the polysilicon layer 4 and the insulation layer 3. Equivalently, the third regions 43 may be elongated in the second lateral direction y. According to one example, a dimension of each of the first, second, and third regions 41, 42, 43 in the second lateral direction y is selected from between 1 micrometer and 300 micrometers, in particular between 10 micrometers and 100 micrometers. Basically, the greater the dimension in the second direction y, the higher the current that can flow through the protection device 2 when a voltage breakdown occurs.

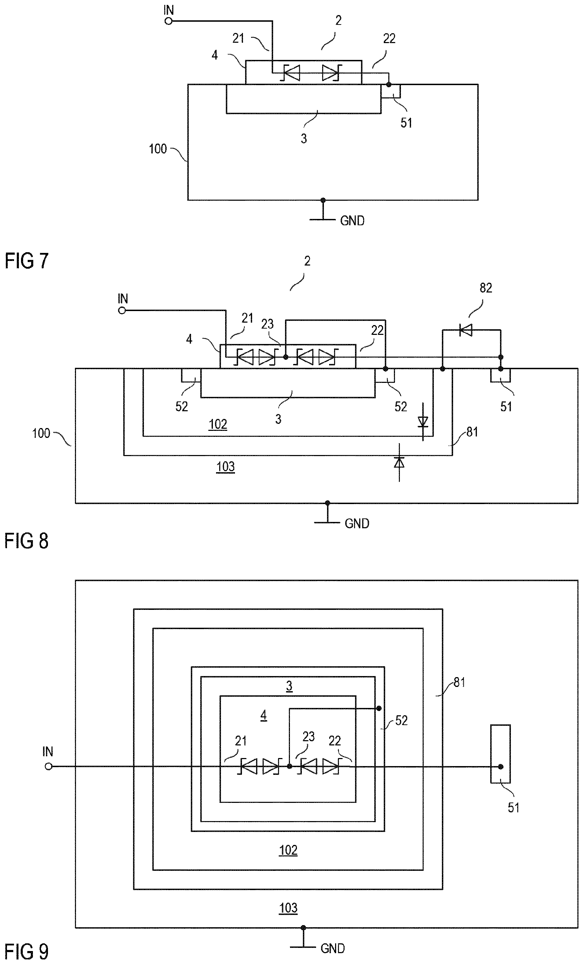

According to one example illustrated in Figure 7, the protection device 2 is connected between the input pin IN and a doped contact region 51 of the semiconductor body 100. More specifically, in the example shown in Figure 7, the input pin IN is connected to the first circuit node 21 and the contact region 51 is connected to the second circuit node 22 of the protection device 2. The protection device 2 may be implemented as bidirectionally blocking protection device (as schematically illustrated in Figure 7) or as a unidirectionally blocking protection device 2. According to one example, the semiconductor body 100 has a basic doping of a certain doping type, wherein a region of the semiconductor body 100 having the basic doping is connected to a ground node GND. According to one example, the contact region 51 has the same doping type as the basic doping and may have a higher doping concentration than the basic doping.

In the electronic circuit according to Figure 7, when a voltage pulse occurs at the input node IN that causes a voltage between the input node IN and the ground node GND to reach a voltage level that is higher than the breakdown voltage of the protection device 2 a breakdown occurs in the protection device 2 between the first circuit node 21 and the second circuit node 22, so that a current flows from the input pin IN via the protection device 2, the doped region 51 and the semiconductor body 100 to the ground node GND and prevents the voltage between the input node IN and the ground node GND from increasing further. The current direction is dependent on a polarity of the voltage pulse received at the input pin. The voltage pulse may be a positive pulse, which is a pulse having a potential higher than ground potential, or a negative pulse, which is a pulse having a potential lower than ground potential.

In the electronic circuit according to Figure 7, when the electrical potential at the input node IN is different from the electrical potential at the ground node GND, there is not only a voltage across the protection device 2 between the first circuit node 21 and the second circuit node 22, but also across the insulation layer 3, wherein the maximum voltage occurs between a region of the polysilicon layer 4 where the first circuit node 21 is located and between regions of the semiconductor body 100 below the insulation layer 3.

Figures 8 and 9 show a modification of the electronic circuit according to Figure 7, wherein in the example according to Figures 7 and 8 the maximum voltage across the insulation layer 3 is reduced. Figure 8 shows a vertical cross sectional view of the semiconductor body 100 in a region where the protection device 2 is arranged, and Figure 9 schematically shows a top view of the semiconductor body 100.

In the example shown in Figures 8 and 9, the protection device 2 includes a tap 23 that is arranged between the first circuit node 21 and the second circuit node 22 and that subdivides the protection device 2 in a first protection device arranged between the first circuit node 21 and the tap 23 and a second protection device arranged between the tap 23 and the second circuit node 22. Each of the first and second protection device may be a bidirectionally blocking device (as illustrated in Figures 8 and 9) or a unidirectionally blocking protection device. The protection device may be implemented in accordance with any of the examples illustrated in Figures 2A - 2B and 3A - 3B, wherein the tap 23 may be formed by one of the first regions 41 and the second regions 42.

Referring to Figures 8 and 9, the second circuit node 22 of the protection device 2 is connected to the contact region 51, which is also referred to as first contact region 51 in the following, and the tap 23 is connected to a further contact region 52, which is also referred to as second contact region 52 in the following. Furthermore, the circuit arrangement includes a doped region 8 of a doping type complementary to the doping type of the basic doping of the semiconductor body 100. The doped region 8, which is referred to as well region 8 in the following, separates a first section 102 having the basic doping type of the semiconductor body 100 from a second section 103 having the basic doping type. The further contact region 52 is arranged in the first section 102. Furthermore, the insulation layer 3 adjoins the first section 102 or is arranged within the first section 102. The contact region 51 is arranged in the second region 103 of the semiconductor body 100. In this arrangement, a first pn junction is formed between the well region 8 and the first section 102 and a second pn junction is formed between the well region 8 and the second section 103.

In the circuit arrangement according to Figures 8 and 9, the electrical potential of the first section 102 essentially equals the electrical potential at the tap 23 of the protection device 2, while the electrical potential of the second section 103 essentially equals ground potential. In this arrangement, the maximum voltage across the insulation layer 3 is given by the voltage between the input node IN and the tap 23, while the voltage between the tap 23 and the second circuit node 22 is absorbed by one of the pn junctions between the well region 8 and the first section 102 or the well region 8 and the second section 103.

According to one example, the tap 23 is located in the protection device 2 such that a voltage blocking capability of the is lower than the voltage blocking capability between the contact regions 51, 52. Dependent on the specific implementation of the protection device 2, the voltage blocking capabilities of the first and second protection devices may be essentially equal or may be different from each other. According to one example, an overall voltage blocking capability of the protection device 2 is selected from between 10V and 300V. In the event that the voltage blocking capabilities of the first and second protection devices are equal, the voltage blocking capability of each of the first protection device and the second protection device is between 5V and 150V.

The pn junctions between the well region 8 and the first and second sections 102, 103 are represented by diodes in the example shown in Figure 8 and 9. The polarity of these diodes is based on the assumption that the doping type of the first and second sections 102, 103 is a p-type and the doping type of the well region is an n-type. This, however, is only an example. According to another example, the doping type of the first and second sections 102, 103 is an n-type and the doping type of the well region is a p-type.

Optionally, the circuit arrangement further includes a further diode 82 connected between the first contact region 51 and the well region 81. This optional diode 82 has a polarity such that the electrical potential of the well region 81 is essentially clamped to the electrical potential of the first contact region 51 plus the forward voltage of the optional diode. In the example shown in Figure 8 this is achieved by connecting the anode of the further diode 82 to the first contact region 51 and connecting the cathode of the further diode 82 to the well region 81. The further diode 82 may be implemented as polysilicon diode on top of an insulation layer, wherein the further diode may include only one first region forming the cathode, only one second region forming the anode and, optionally, a third region arranged between the anode and the cathode. The insulation layer may be the same insulation layer as the insulation layer on top of which the protection device 2 is formed, or a different insulation layer.

According to another example (not shown), diode 82 is connected between the first contact region 51 and the well region 81 such that the anode of diode 82 is connected to the well region and the cathode is connected to the first contact region 51. In this example, diode 81 limits (clamps) a voltage between the contact region 51 and the well region 81 to a voltage level that is given by a breakdown voltage of the diode 82.

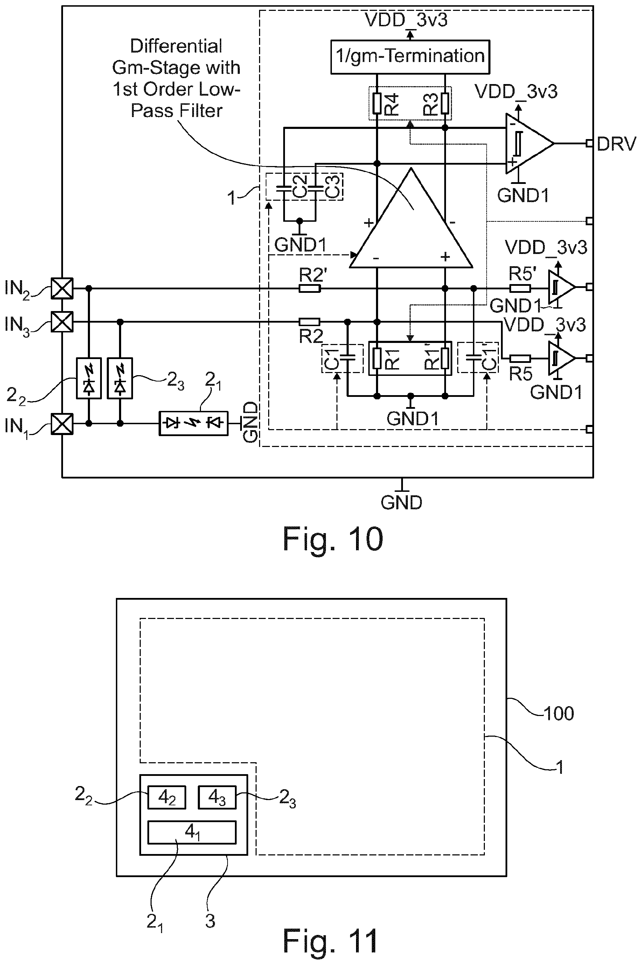

Figure 10 illustrates an equivalent circuit diagram of a circuit arrangement according to one example. In this circuit arrangement, the electronic circuit 1 integrated in the semiconductor body includes a CMOS circuit with a differential amplifier (differential stage).

Referring to Figure 10, the circuit arrangement includes three input pins IN₁, IN₂, IN₃, wherein the first and second input pins IN₂, IN₃ are configured to receive a differential input signal. More specifically, a second input pin IN₂ is configured to receive a first input signal referenced to a first input pin IN₁ and a third input pin IN₃ is configured to receive a second input signal that is also referenced to the first input pin INi, wherein the first and second input signals form a differential signal pair. According to one example, a first protection device 2₁ is connected between the first input pin IN₁ and the ground node GND of the semiconductor body 100 (which is not shown in Figure 10), a second protection device 2₂ is connected between the second input pin IN₂ and the first input pin IN₁, and a third protection device 2₃ is connected between the third input pin IN₃ and the first input pin IN₁.

According to one example, the first protection device 2₁ is a bidirectionally blocking protection device, wherein the voltage blocking capability of this protection device is selected from between 50V and 200V. According to one example, each of the first and second protection devices 2₂, 2₃ is a unidirectionally blocking protection device, wherein polarities of these protection devices are such that they prevent electrical potentials at the second and third input nodes IN₂, IN₃ from increasing to above voltage blocking capabilities as defined by the first and second protection devices 2₂, 2₃. According to one example, voltage blocking capabilities of the first and second protection devices are selected from between 5V and 30V, for example.

In the example shown in Figure 10, the electronic circuit 1 is a drive circuit that is configured to output a drive signal DRV that may be received by a high side switch (not shown) of a half-bridge. In addition to the high-side switch, the half-bridge includes a low-side switch (not shown) connected in series with the high-side switch. Each of the high-side switch and the low side switch is an n-type MOSFET (Metal Oxide Semiconductor Field-Effect Transistor), for example. According to one example, the drive signal DRV is a voltage that is referenced to a further ground node GND1, which is different from the ground node GND explained above. The drive circuit 1 is configured to generate the drive signal DRV based on a differential signal, which includes a first input voltage received between the second input node IN₂ and the first input node IN₂, and a second input voltage received between the third input node IN₃ and the first input node IN₁, wherein the drive circuit 1 includes a level shifter functionality so that the drive signal DRV is referenced to the ground node GND1 that is different from (and higher than) the ground node coupled to the first, second, and third input nodes IN₁, IN₂, IN3.

Figure 11 schematically illustrates a top view of the semiconductor body 100, wherein Figure 11 illustrates where the electronic circuit 2 and the protection devices may be arranged. In the example shown in Figure 11, the first protection device 2₁ is integrated in a first polysilicon layer 4₁, the second protection device 2₂ is integrated in a second polysilicon layer 4₂, and the third protection device 4₃ is integrated in a third polysilicon layer 4₃. These polysilicon layers 4₁, 4₂, 4₃ may be arranged on top of the same insulation layer 3 and are spaced apart from each other. The insulation layer 3 may be arranged in a section of the semiconductor body 100 that is spaced apart from those sections in which the electronic circuit 1 is integrated. Each of the first, second and third protection devices 4i, 4₂, 4₃ may be implemented in accordance with any of these examples explained herein before.

Forming the protection devices 2₁ - 2₃ in separate polysilicon layers 4₁ - 4₃ on top of the same insulation layer 3 is only an example. According to another example, the circuit arrangement includes several insulation layers that are spaced apart from each other, wherein each of the polysilicon layers 4₁ - 4₃ is formed on a respective one of these insulation layers.

Some of the aspects explained above are summarized in the following by way of numbered examples.

Example 1. A circuit arrangement, including: an electronic circuit integrated in a semiconductor body; an input pin coupled to the electronic circuit; an insulation layer formed on top of the semiconductor body; and a protection device connected to the input pin, wherein the protection device is integrated in a polysilicon layer formed on top of the insulation layer.

Example 2. The circuit arrangement of example 1, wherein the protection device includes: a plurality of first regions of a first doping type and plurality of second regions of a second doping type complementary to the first doping type, wherein the first regions and the second regions are arranged alternatingly in the polysilicon layer.

Example 3. The circuit arrangement of example 2, wherein the protection device further includes: a plurality of third regions, wherein each third region is arranged between a respective one of the first regions and a respective one of the second regions.

Example 4. The circuit arrangement of example 3, wherein each of the first regions is separated from each neighboring second region by a respective one of the third regions.

Example 5. The circuit arrangement of example 3, wherein at least some of the first regions each adjoin a respective one of the second regions to form a respective pn-junction, and wherein at least some of the pn-junctions are bypassed by an electrical connection.

Example 6. The circuit arrangement of any one of examples 3 to 5, wherein each of the third regions is an intrinsic region or a lowly doped region.

Example 7. The circuit arrangement of any one of examples 1 to 7, further including: a plurality of cooling fins formed in a further insulation layer on top of the polysilicon layer, wherein each cooling fin is connected to at least one of the first regions and the second regions.

Example 8. The circuit arrangement of example 7, wherein each cooling fin is connected only to a respective one of the first regions and the second regions.

Example 9. The circuit arrangement of example 7, wherein at least some of the cooling fins are each connected to a respective first region and a second region adjoining the respective first region in order to bypass a pn-junction formed between the respective first region and the adjoining second region.

Example 10. The circuit arrangement of any one of examples 1 to 9, wherein a thickness of the polysilicon layer is between 50 nanometers and 300 nanometers.

Example 11. The circuit arrangement of any one of examples 1 to 10, wherein the plurality of first regions includes between 3 and 30 first regions, and wherein the plurality of second regions includes between 3 and 30 second regions.

Example 12. The circuit arrangement of any one of examples 3 to 11, wherein a width of each of the third regions is between 0.1 micrometers and 1 micrometer.

Example 13. The circuit arrangement of any one of examples 1 to 12, wherein the protection device is connected between the input and a first contact region of the semiconductor body.

Example 14. The circuit arrangement of example 13, wherein the protection device includes a tap connected to a second contact region of the semiconductor body, wherein each of the first contact region and the second contact region has a first doping type, wherein the semiconductor body includes a doped region of a second doping type complementary to the first doping type, wherein the doped region separates the first contact region from the second contact region.

Example 15. The circuit arrangement of any one of examples 1 to 14, wherein the input is a first input, wherein the protection device is a first protection device, and wherein the circuit arrangement further includes at least one further input and at least one further protection device connected to the at least one further input.

## Claims

1. A circuit arrangement, comprising:
an electronic circuit (1) integrated in a semiconductor body (100);
an input pin (IN) coupled to the electronic circuit (1);
an insulation layer (3) formed on top of the semiconductor body (100); and
a protection device (2) connected to the input pin (IN),
wherein the protection device is integrated in a polysilicon layer (4) formed on top of the insulation layer (3).

2. The circuit arrangement of claim 1, wherein the protection device (2) comprises:
a plurality of first regions (41) of a first doping type and plurality of second regions (42) of a second doping type complementary to the first doping type,
wherein the first regions (41) and the second regions (42) are arranged alternatingly in the polysilicon layer (4).

3. The circuit arrangement of claim 2, wherein the protection device (2) further comprises:
a plurality of third regions (43),
wherein each third region (43) is arranged between a respective one of the first regions (41) and a respective one of the second regions (42).

4. The circuit arrangement of claim 3,
wherein each of the first regions (41) is separated from each neighboring second region (42) by a respective one of the third regions (43).

5. The circuit arrangement of claim 3,
wherein at least some of the first regions (41) each adjoin a respective one of the second regions (42) to form a respective pn-junction, and
wherein at least some of the pn-junctions are bypassed by an electrical connection.

6. The circuit arrangement of any one of claims 3 to 5, wherein each of the third regions (43) is an intrinsic region or a lowly doped region.

7. The circuit arrangement of any one of the preceding claims, further comprising:
a plurality of cooling fins (71, 72) formed in a further insulation layer (6) on top of the polysilicon layer (4),
wherein each cooling fin (71, 72) is connected to at least one of the first regions (41) and the second regions (42).

8. The circuit arrangement of claim 7,
wherein each cooling fin (71) is connected only to a respective one of the first regions (41) and the second regions (42).

9. The circuit arrangement of claim 7,
wherein at least some of the cooling fins (71) are each connected to a respective first region (41) and a second region (42) adjoining the respective first region (41) in order to bypass a pn-junction formed between the respective first region (41) and the adjoining second region (42).

10. The circuit arrangement of any one of the preceding claims,
wherein a thickness (h) of the polysilicon layer (4) is between 50 nanometers and 300 nanometers.

11. The circuit arrangement of any one of the preceding claims,
wherein the plurality of first regions (41) comprises between 3 and 30 first regions, and
wherein the plurality of second regions (42) comprises between 3 and 30 second regions.

12. The circuit arrangement of any one of claims 3 to 11,
wherein a width of each of the third regions (43) is between 0.1 micrometers and 1 micrometer.

13. The circuit arrangement of any one of the preceding claims,
wherein the protection device (2) is connected between the input (IN) and a first contact region (51) of the semiconductor body (100).

14. The circuit arrangement of claim 13,
wherein the protection device (21) comprises a tap (23) connected to a second contact region (52) of the semiconductor body (100),
wherein each of the first contact region (51) and the second contact region (52) has a first doping type,
wherein the semiconductor body (100) comprises a doped region (81) of a second doping type complementary to the first doping type,
wherein the doped region (81) separates the first contact region (51) from the second contact region (52).

15. The circuit arrangement of any one of the preceding claims,
wherein the input is a first input (INi),
wherein the protection device is a first protection device (2₁),
and wherein the circuit arrangement further comprises at least one further input (IN₂, IN₃) and at least one further protection device (2₂, 2₃) connected to the at least one further input (IN₂, IN₃).
